# EUROPEAN PATENT APPLICATION

(11) **EP 3 940 786 A1**
(43) Date of publication of application: **19.01.2022**
(21) Application number: 21185201.7
(22) Date of filing: 13.07.2021
(51) Int. Cl.: H01L 27/32, H04M 1/02

(54) **DISPLAY DEVICE**

(30) Priority: 15.07.2020 KR 20200087503
(71) Applicant: Samsung Display Co., Ltd., Gyeonggi-do 17113 (KR)
(72) Inventor: KIM, Younggu, 234-201 Hwaseong-si, Gyeonggi-do (KR); KIM, Minki, 415-1703 Hwaseong-si, Gyeonggi-do (KR); LEE, Joohyung, 205-403 Suji-gu, Yongin-si, Gyeonggi-do (KR); BAEK, In-Su, C-103 Yeongdeungpo-gu, Seoul (KR); CHUNG, Min-Suk, 302-ho Songpa-gu, Seoul (KR)
(74) Representative: Dr. Weitzel & Partner

(57) **Abstract**

A display device includes a display panel, a supporting member supporting the display panel, a filling member disposed under the supporting member and overlapping a first area of the supporting member, a heat-releasing member disposed under the supporting member and overlapping a second area of the supporting member, and a light-blocking member. The supporting member includes an opening which overlaps a portion of the display panel. The filling member includes an opening which overlaps the opening of the supporting member. The light-blocking member is disposed in the opening of the filling member and overlaps the opening of the supporting member.

## Description

### BACKGROUND

### 1. Technical Field

Embodiments of the disclosure relate to a display device.

### 2. Description of the Related Art

A display device displays an image in response to an electric signal applied thereto thereby providing a visual information to users.

A display device may include a display panel and a functional module such as a cameral module, a sensor module or the like. The functional module may be disposed under the display panel to substantially expand a display area and to improve a design of the display device. For example, the functional module may detect or sense an article, a user, or the like in front of the display device by using light which passes through the display module and enters the functional module.

### SUMMARY

Embodiments provide a display device having a substantially enlarged display area and an improved reliability.

According to an embodiment, a display device includes a display panel, a supporting member supporting the display panel, a filling member disposed under the supporting member and overlapping a first area of the supporting member, a heat-releasing member disposed under the supporting member and overlapping a second area of the supporting member, and a light-blocking member. The supporting member includes an opening which overlaps a portion of the display panel. The filling member includes an opening which overlaps the opening of the supporting member. The light-blocking member is disposed in the opening of the filling member and overlaps the opening of the supporting member.

In an embodiment, the display device further includes a protective film overlapping lower surfaces of the filling member, the heat-releasing member and the light-blocking member.

In an embodiment, the light-blocking member may have a thickness substantially equal to a thickness of the filling member.

In an embodiment, the filling member may have a thickness substantially equal to a thickness of the heat-releasing member.

In an embodiment, the filling member may transmit light.

In an embodiment, the heat-releasing member may include graphite.

In an embodiment, the display panel may be an organic light-emitting display panel.

In an embodiment, the display panel may include a first display area and a second display area which have different light transmittances in a unit area. The second display area may overlap the opening of the supporting member.

In an embodiment, a number of pixels in a unit area in the second display area may be less than a number of pixels in a unit area in the first display area.

In an embodiment, the display device may further include an adhesive member disposed between the supporting member and the display panel, the adhesive member including a light-blocking material.

In an embodiment, the supporting member may include a plurality of openings.

According to an embodiment, a display device may include a display panel, a supporting member supporting the display panel, a filling member disposed under the supporting member and overlapping a first area of the supporting member, a heat-releasing member disposed under the supporting member and overlapping a second area of the supporting member, a protective film overlapping lower surfaces of the filling member and the heat-releasing member, and a light-blocking layer combined with the protective film or the filling member. The supporting member may include an opening which overlaps a portion of the display panel. The light-blocking layer may overlap the opening of the supporting member.

In an embodiment, the light-blocking layer may be disposed on a lower surface of the protective film.

In an embodiment, the light-blocking layer may be disposed between the protective film and the filling member.

In an embodiment, the light-blocking layer may be disposed on an upper surface of the protective film and may contact the supporting member.

In an embodiment, the filling member and the protective film may transmit a light.

In an embodiment, the heat-releasing member may include graphite.

In an embodiment, the display panel may be an organic light-emitting display panel.

In an embodiment, the display panel may include a first display area and a second display area which have different light transmittances in a unit area, and the second display area may overlap the opening of the supporting member.

In an embodiment, a number of pixels in a unit area in the second display area may be less than a number of pixels in a unit area in the first display area.

According to embodiments, a display device may include a light-blocking member which blocks light entering a display panel through an opening of a supporting member. Thus, image deterioration such as Mura effect may be prevented.

Furthermore, the light-blocking member is selectively disposed on an area overlapping the opening of the supporting member, and a filling member capable of transmitting light is disposed on other area. Thus, an inspection process for detecting exterior defects of the display panel assembly will be performed by using the area where the filling member is disposed.

Furthermore, the light-blocking member may have a thickness substantially equal to the filling member adjacent thereto. Thus, deterioration of adhesion of a protective film attached to lower surfaces of the light-blocking member and the filling member may be prevented.

### BRIEF DESCRIPTION OF THE DRAWINGS

Aspects of one or more embodiments of the disclosure will be more clearly understood from the following detailed description taken in conjunction with the accompanying drawings.
FIG. 1 is a schematic rear view illustrating a display device according to an embodiment.
FIG. 2 is a schematic cross-sectional view taken along line I-I' of FIG. 1.
FIG. 3 is a schematic plan view illustrating a display panel according to an embodiment.
FIG. 4 is a schematic enlarged plan view illustrating a first display area of a display panel according to an embodiment.
FIG. 5 is a schematic enlarged plan view illustrating a second display area of a display panel according to an embodiment.
FIG. 6 is a schematic cross-sectional view illustrating a display panel according to an embodiment, taken along line II-II' of FIG. 4.
FIG. 7 is a schematic cross-sectional view illustrating a display panel according to an embodiment, taken along the line III-III' of FIG. 5.
FIGS. 8, 9 and 10 are schematic rear views illustrating a display device according to embodiments.
FIGS. 11, 12 and 13 are schematic cross-sectional views illustrating a display device according to embodiments.

### DETAILED DESCRIPTION OF THE EMBODIMENTS

A display device according to embodiments of the disclosure will be described hereinafter with reference to the accompanying drawings, in which some embodiments are shown.

In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

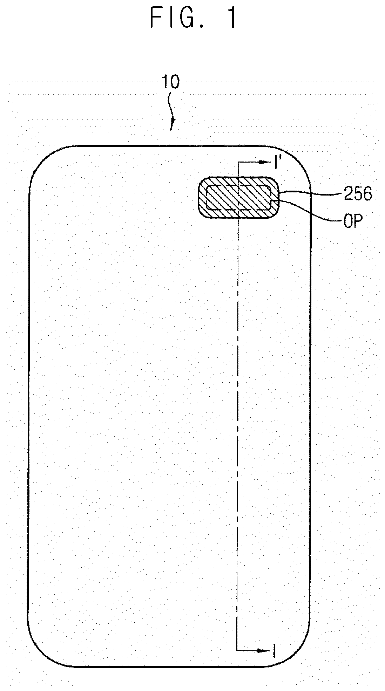

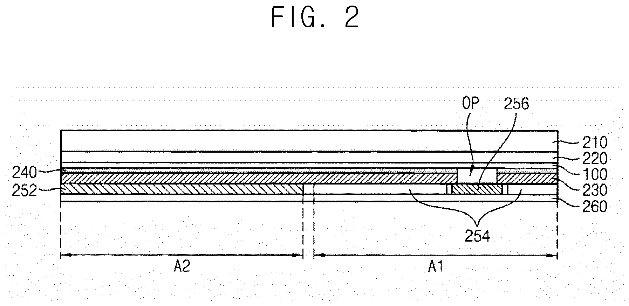

FIG. 1 is a schematic rear view illustrating a display device according to an embodiment. FIG. 2 is a schematic cross-sectional view taken along line I-I' of FIG. 1.

The display device 10 illustrated in FIGS. 1 and 2 may be a display panel assembly including a display panel.

Referring to FIGS. 1 and 2, a display panel assembly includes a display panel 100, a supporting member 230 disposed under the display panel 100 and including an opening OP, and a light-blocking member 256 disposed under the supporting member 230 and covering or overlapping the opening OP. In an embodiment, the display panel assembly includes a filling member 254 disposed under the supporting member 230 and overlapping a first area A1 of the supporting member 230, a heat-releasing member 252 disposed under the supporting member 230 and overlapping a second area A2 of the supporting member 230, a protective window 210 covering or overlapping a front surface of the display panel 100, a polarization member 220 disposed between the protective window 210 and the display panel 100, an adhesive member 240 combining the display panel 100 and the supporting member 230, and a protective film 260 overlapping lower surfaces of the heat-releasing member 252 and the filling member 254.

The protective window 210 may include a light-transmitting area, which overlaps a display area of the display panel 100. For example, the protective window 210 may include a glass, a polymeric material, or a combination thereof.

The polarization member 220 may include a polarization layer. For example, the polarization layer may include a polyvinylalcohol (PVA) film drawn or elongated in a direction.

The supporting member 230 may include a rigid material such as a metal. For example, the supporting member 130 may include stainless steel, aluminum, or a combination thereof.

The adhesive member 240 may combine the supporting member 230 with the display panel 100. For example, the adhesive member 240 may be formed of an adhesive material including an acrylic resin or the like. The adhesive member 240 may further include a light-blocking material such as carbon black. The adhesive member 240 may include an opening, which overlaps the opening OP of the supporting member 230. Thus, a portion of a lower surface of the display panel 100 may be exposed through the opening of the adhesive member 240 and the opening OP of the supporting member 230.

The heat-releasing member 252 includes a heat-releasing material. For example, the heat-releasing member 252 may include graphite, ceramic, or a combination thereof. For example, the heat-releasing member 252 may have a film or sheet shape, which includes the heat-releasing material dispersed in a resin. The heat-releasing member 252 may overlap a portion of a lower surface of the supporting member 230. For example, the heat-releasing member 252 may release heat generated in a heat source such as a battery disposed thereunder.

The filling member 254 may be disposed in an area where the heat-releasing member 252 is not disposed. If the display panel assembly does not include the filling member 254, adhesion of the protective film 260 may be reduced by a height difference between the area with the heat-releasing member 252 and the area without the heat-releasing member 252. Thus, a protective film 260 may be undesirably separated from the display panel assembly.

For example, the filling member 254 may include a polymeric film. For example, the filling member 254 may include a polymer such as polyester, polyethyleneterephthalate, polyamide, polymethylmethacrylate, polycarbonate, polyolefin, polyurethane, or the like. In an embodiment, the filling member 254 may have a thickness equal or similar to a thickness of the heat-releasing member 252. Referring to FIG. 2, the filling member 254 may be spaced apart from the heat-releasing member 252. However, embodiments are not limited thereto. For example, a side surface of the filling member 254 may contact a side surface of the heat-releasing member 252. In an embodiment, the filling member 254 may be transparent or half-transparent so that light may pass through the filling member 254.

The protective film 260 may include a polymeric film. For example, the protective film 260 may include a polymer such as polyester, polyethyleneterephthalate, polyamide, polymethylmethacrylate, polycarbonate, polyolefin, polyurethane, or the like. In an embodiment, the protective film 260 may be transparent or half-transparent so that light may pass through the protective film 260.

The light-blocking member 256 may be disposed in the first area A1. For example, the filling member 254 may include an opening, which receives the light-blocking member 256, and the light-blocking member 256 may be disposed in the opening of the filling member 254. For example, the filling member 254 may have a shape surrounding the light-blocking member 256 in a plan view.

The light-blocking member 256 may include a light-blocking material. For example, the light-blocking member 256 may include a pigment, a dye, or a combination thereof. For example, the light-blocking member 256 may include a conventional light-blocking material such as carbon black. In an embodiment, the light-blocking member 256 may have a thickness equal or similar to a thickness of the filling member 254 adjacent thereto. The light-blocking member 256 may have a size larger than that of the opening OP of the supporting member 230 in a plan view to entirely overlap the opening OP of the supporting member 230. For example, the light-blocking member 256 may have a sheet shape, a film shape, a tape shape, or the like.

In case that external light enters an area of a rear surface of the display panel 100, image deterioration such as Mura effect may occur in the area which the external light enters by for example a driving current difference. In an embodiment, the light-blocking member 256 may block light entering the display panel 100 through the opening OP of the supporting member 230. Thus, image deterioration such as Mura effect may be prevented.

The light-blocking member 256 may be selectively disposed only in an area overlapping the opening OP of the supporting member 230, and the filling member 254 capable of transmitting light may be disposed in other areas. Thus, an inspection process for detecting defects in the exterior of the display panel assembly may be performed through the area where the filling member 254 is disposed.

The light-blocking member 256 may have a thickness substantially equal to that of the filling member 254 adjacent thereto. Thus, deterioration of adhesion of the protective film 260 attached to lower surfaces of the light-blocking member 256 and the filling member 254 may be prevented.

In an embodiment, the display device 10 may include a functional module disposed under the display panel 100. Examples of the functional module may include a camera module, a face recognition sensor module, an iris recognition sensor module, an acceleration sensor module, a geomagnetism sensor module, a proximity sensor module, an infrared (IR) sensor module, an illumination sensor module, or the like. The cameral module may be used for imaging an object in front of the display device 10. The face recognition sensor module may be used for recognizing a face of a user. The iris recognition sensor module may be used for recognizing an iris of a user. The acceleration sensor module and the geomagnetism sensor module may be used for determining movement of the display device 10. The proximity sensor module and IR sensor module may be used for sensing an object getting close to the display device 10. The illumination sensor module may be used for measuring an external brightness.

For example, the functional module may overlap the opening OP of the supporting member 230. For example, the light-blocking member 256 may be removed in case that the display panel assembly is combined with the functional module. Thus, the functional module may detect or sense an article or a person in front of the display device 10 based on an external light entering the functional module through the display panel 100 and the opening OP. The display panel 100 may include a light-transmitting area to increase an amount of light entering the functional module. Configurations for the light-transmitting area will be explained hereinafter.

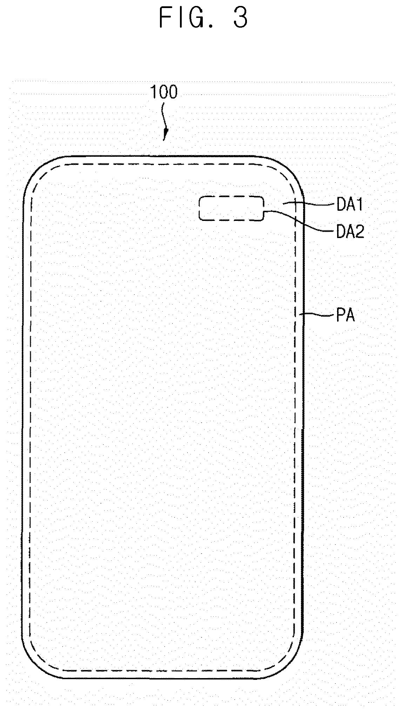

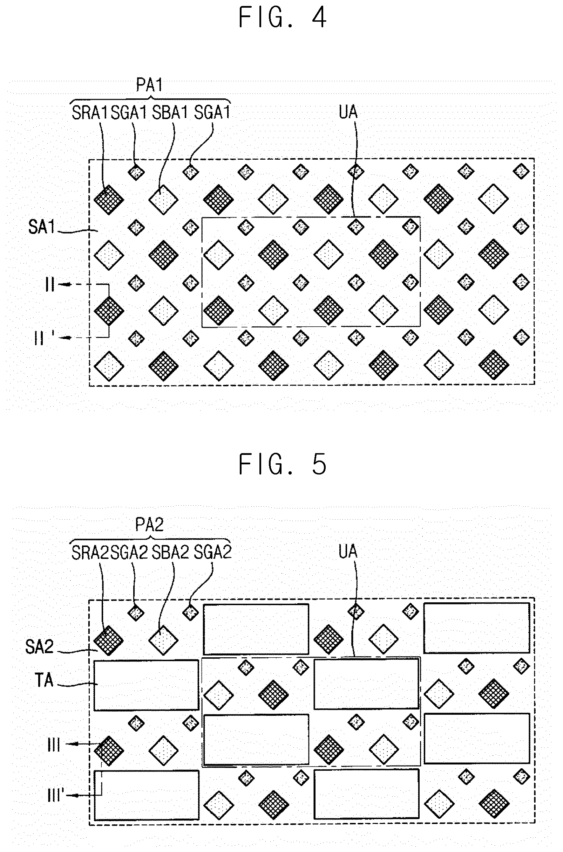

FIG. 3 is a schematic plan view illustrating a display panel according to an embodiment. FIG. 4 is a schematic enlarged plan view illustrating a first display area of a display panel according to an embodiment. FIG. 5 is a schematic enlarged plan view illustrating a second display area of a display panel according to an embodiment.

Referring to FIG. 3, a display panel 100 may include a display area and a peripheral area PA adjacent to or surrounding the display area.

In an embodiment, the display area may include a first display area DA1 and a second display area DA2. The first display area DA1 and the second display area DA2 may each display an image. The second display area DA2 may include a light-transmitting area that transmits external light. Thus, the second display area DA2 may transmit external light incident thereon and/or display an image. The first display area DA1 and the second display area DA2 may be adjacent to each other. For example, the first display area DA1 may have a shape surrounding the second display area DA2 in a plan view. The second display area DA2 may overlap an opening OP of a supporting member of a display panel assembly.

For example, the light-transmitting area may be defined by an area where elements of a pixel for generating a light are partially removed to increase the light transmittance. In an embodiment, the light-transmitting area may be defined by an opening that is formed by removing a common electrode disposed in the entire display area. At least one of a pixel electrode, a metal wiring, an organic insulation layer, and an inorganic insulation layer may be removed from the light-transmitting area to further increase the light transmittance.

Referring to FIGS. 4 and 5, the first display area DA1 may include a first pixel area PA1 and a first adjacent area SA1, and the second display area DA2 may include a second pixel area PA2, a light-transmitting area TA, and a second adjacent area SA2. Pixels may be disposed in the first pixel area PA1 and the second pixel area PA2, and light generated by the pixels may be emitted from the first pixel area PA1 and the second pixel area PA2.

The first pixel area PA1 may include first subpixel areas SRA1, SGA1, and SBA1, which emit lights having different colors from each other. The second pixel area PA2 may include second subpixel areas SRA2, SGA2, and SBA2, which emit lights having different colors from each other. In an embodiment, the first subpixel areas SRA1, SGA1, and SBA1 may include a first red pixel area SRA1 emitting red light, a first green pixel area SGA1 emitting green light, and a first blue pixel area SBA1 emitting blue light. The second subpixel areas SRA2, SGA2, and SBA2 may include a second red pixel area SRA2 emitting red light, a second green pixel area SGA2 emitting green light, and a second blue pixel area SBA2 emitting blue light. However, embodiments are not limited thereto, and the number of the subpixels disposed in the second pixel area PA2 may be varied.

The light-transmitting area TA may transmit external light incident on the display panel 100. For example, the first adjacent area SA1 may surround the first pixel area PA1. The second adjacent area SA2 may surround the second pixel area PA2 and the light-transmitting area TA. The first adjacent area SA1 and the second adjacent area SA2 do not emit a light. The first adjacent area SA1 and the second adjacent area SA2 may be defined as an area substantially blocking an external light or an area having a light transmittance less than a minimum light transmittance required for the functional module.

Since the second display area DA2 includes the light-transmitting area TA, the number of the second subpixel areas SRA2, SGA2, and SBA2 disposed in a unit area UA may be smaller than the number of the first subpixel areas SRA1, SGA1, and SBA1 disposed in a unit area UA. Thus, a light transmittance of the second display area DA2 in a unit area UA may be greater than a light transmittance of the first display area DA1 in a unit area UA. In an embodiment, an area of the light-transmitting area TA in the second display area DA2 may be equal to or greater than 1/2 of an entire area of the second display area DA2. For example, the second pixel area PA2 and the light-transmitting area TA may be alternately arranged in the second display area DA2.

In an embodiment, the number of the second subpixel areas SRA2, SGA2, and SBA2 disposed in a unit area UA may be 1/2 of the number of the first subpixel areas SRA1, SGA1, and SBA1 in a unit area UA. For example, as illustrated in FIGS. 4 and 5, in case that the number of the first subpixel areas SRA1, SGA1, and SBA1 in a unit area UA is 16, the number of the second subpixel areas SRA2, SGA2, and SBA2 disposed in a unit area UA may be eight (8).

In an embodiment, arrangement of the second subpixel areas SRA2, SGA2, and SBA2 may be substantially identical to that of the first subpixel areas SRA1, SGA1 and SBA1.

In an embodiment, a size of the second subpixel areas SRA2, SGA2, and SBA2 may be substantially equal to a size of the first subpixel areas SRA1, SGA1, and SBA1. For example, the second red pixel area SRA2, the second green pixel area SGA2, and the second blue pixel area SBA2 may have sizes substantially equal to those of the first red pixel area SRA1, the first green pixel area SGA1, and the first blue pixel area SBA1, respectively.

However, embodiments are not limited thereto. For example, at least one of the second subpixel areas SRA2, SGA2, and SBA2 may have a size larger than a corresponding one of the first subpixel areas SRA1, SGA1, and SBA1. The first display area DA1 and the second display area DA2 may have different subpixel configurations. For example, the first display area DA1 may include subpixel areas with a stripe configuration wherein the subpixel areas are arranged in a direction in a pixel area, and the second display area DA2 may include subpixel areas with a PenTile^{®} configuration as illustrated in FIG. 5.

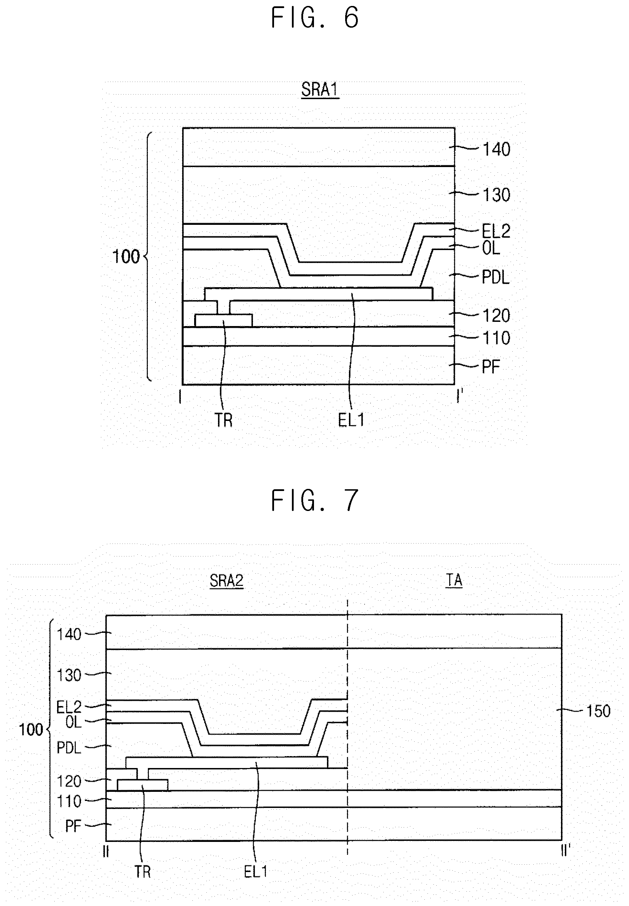

FIG. 6 is a schematic cross-sectional view illustrating a display panel according to an embodiment, taken along line II-II' of FIG. 4. FIG. 7 is a schematic cross-sectional view illustrating a display panel according to an embodiment, taken along line III-III' of FIG. 5. For example, FIG. 6 illustrates a cross-section of the first red subpixel area SRA1, and FIG. 7 illustrates a cross-section of the second red subpixel area SRA2 and the light-transmitting area TA adjacent thereto.

Referring to FIG. 6, the display panel 100 may include a driving element TR disposed on a base substrate 110 in the first display area DA1. The driving element TR may be electrically connected to a corresponding light-emitting element. The light-emitting element may be an organic light-emitting diode. For example, the organic light-emitting diode may include a first electrode EL1, a second electrode EL2, and an organic light-emitting layer OL disposed between the first electrode EL1 and the second electrode EL2.

For example, the base substrate 110 may include glass, quartz, sapphire, a polymeric material, or the like. In an embodiment, a protective film PF may be disposed under the base substrate 110.

In an embodiment, the driving element TR may include a thin film transistor. The driving element TR may include thin film transistors.

For example, a channel layer of the thin film transistor may include amorphous silicon, multi-crystalline silicon (polysilicon), or a metal oxide. For example, the metal oxide may include a binary compound (ABₓ), a ternary compound (ABₓC_{y}) or a quaternary compound (ABₓC_{y}D_{z}), which contains indium (In), zinc (Zn), gallium (Ga), tin (Sn), titanium (Ti), aluminum (Al), hafnium (Hf), zirconium (Zr), magnesium (Mg), or the like. For example, the metal oxide may include zinc oxide (ZnOₓ), gallium oxide (GaOₓ), titanium oxide (TiOₓ), tin oxide (SnOₓ), indium oxide (InOₓ), indium-gallium oxide (IGO), indium-zinc oxide (IZO), indium tin oxide (ITO), gallium zinc oxide (GZO), zinc magnesium oxide (ZMO), zinc tin oxide (ZTO), zinc zirconium oxide (ZnZrₓO_{y}), indium-gallium-zinc oxide (IGZO), indium-zinc-tin oxide (IZTO), indium-gallium-hafnium oxide (IGHO), tin-aluminum-zinc oxide (TAZO), indium-gallium-tin oxide (IGTO), or the like.

The driving element TR may be covered or overlapped by an insulation structure 120. The insulation structure 120 may include a combination of an inorganic insulation layer and an organic insulation layer.

The first electrode EL1 may function as an anode. For example, the first electrode EL1 may be formed as a light-transmitting electrode or a reflecting electrode according to an emission type of the display device 10 (a front emission type or a rear emission type). In case that the first electrode EL1 is a reflecting electrode, the first electrode EL1 may include gold (Au), silver (Ag), aluminum (Al), copper (Cu), nickel (Ni), platinum (Pt), magnesium (Mg), chromium (Cr), tungsten (W), molybdenum (Mo), titanium (Ti), or a combination thereof, and may have a stacked structure further including a metal oxide layer including indium tin oxide, indium zinc oxide, zinc tin oxide, indium oxide, zinc oxide, tin oxide or a combination thereof.

A pixel-defining layer PDL may be disposed on the insulation structure 120 and may have an opening exposing at least a portion of the first electrode EL1. For example, the pixel-defining layer PDL may include an organic insulating material. At least a portion of the organic light-emitting layer OL may be disposed in the opening of the pixel-defining layer PDL. In an embodiment, the organic light-emitting layer OL may extend continuously over the pixel areas in the display area. In another embodiment, an organic light-emitting layer may be formed as an isolated pattern corresponding to each of the subpixel areas.

The organic light-emitting layer OL may have a single-layered structure or a multi-layered structure, which includes at least an emission layer and may further include at least one functional layer of a hole-injection layer (HIL), a hole-transporting layer (HTL), an electron-transporting layer (ETL), and an electron-injection layer (EIL). For example, the organic light-emitting layer OL may include an emission layer patterned to correspond to each of the subpixel areas and a common layer including at least one of the hole-injection layer, a hole-transporting layer, an electron-transporting layer, and the electron-injection layer.

In an embodiment, the organic light-emitting layer OL may generate lights corresponding to the subpixel areas. For example, the organic light-emitting layer OL disposed in the first red subpixel area SRA1 may generate red light.

The second electrode EL2 may be formed as a light-transmitting electrode or a reflecting electrode according to an emission type of the display device 10. For example, the second electrode EL2 may include a metal, a metal alloy, a metal nitride, a metal fluoride, a conductive metal oxide, or a combination thereof. For example, the second electrode EL2 may be formed as a common layer extending continuously over pixel areas in the display areas.

The display panel 100 may further include an encapsulation layer 130 covering organic light-emitting diodes. The encapsulation layer 130 may extend to cover or overlap substantially the entire display areas.

For example, the encapsulation layer 130 may have a stacked structure of an inorganic thin film and an organic thin film. For example, the organic thin film may include a cured resin such as polyacrylate or the like. For example, the inorganic thin film may include an inorganic material such as silicon oxide, silicon nitride, silicon carbide, aluminum oxide, tantalum oxide, hafnium oxide, zirconium oxide, titanium oxide, or the like.

In an embodiment, a touch-sensing part 140 may be disposed on the encapsulation layer 130. The touch-sensing part 140 may include a driving electrode extending in a first direction and a sensing electrode extending in a second direction to intersect the driving electrode. For example, the driving electrode and the sensing electrode may each include electrode patterns disposed on a same layer. Electrode patterns of one of the driving electrode and the sensing electrode may be continuously connected to (or integral with) each other, and electrode patterns of the other of the driving electrode and the sensing electrode may be electrically connected to each other through a bridge pattern disposed on a different layer from the electrode patterns.

Referring to FIG. 7, the display panel 100 may include a driving element TR disposed on a base substrate 110 in the second display area DA2. The driving element TR may be electrically connected to a corresponding light-emitting element. The light-emitting element may be an organic light-emitting diode. For example, the organic light-emitting diode may include a first electrode EL1, a second electrode EL2, and an organic light-emitting layer OL disposed between the first electrode EL1 and the second electrode EL2.

The display panel 100 may include a light-transmitting part 150 in the light-transmitting area TA of the second display area DA2. For example, the light-transmitting part 150 may be defined by an area between the touch-sensing part 140 and the base substrate 110. The light-transmitting part 150 may have a configuration different from the subpixel area (e.g., SRA2) adjacent thereto to increase the light transmittance.

In an embodiment, the light-transmitting part 150 may not include at least the electrodes EL1 and EL2 of the organic light-emitting diode and conductive layers forming the driving element TR. Thus, the light-transmitting part 150 may include an insulation structure, an organic light-emitting layer, and an encapsulation layer. In another embodiment, the light-transmitting part 150 may include an organic light-emitting layer and an encapsulation layer.

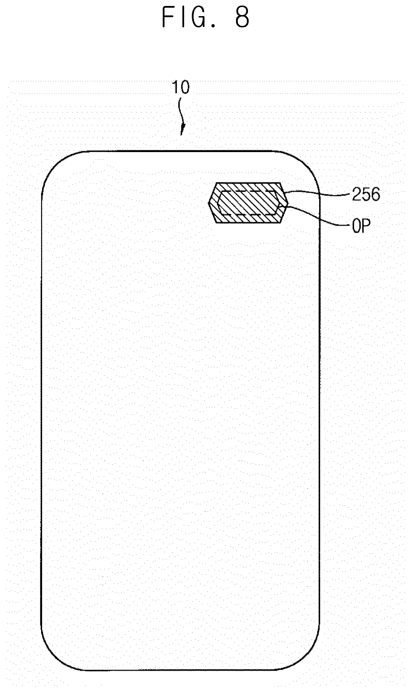

FIGS. 8, 9, and 10 are schematic rear views illustrating a display device according to embodiments. In embodiments, an opening of a supporting member and a light-blocking member may have various configurations and various shapes.

Referring to FIG. 8, a display device 10 may include a supporting member including opening OP and a light-blocking member 256 covering or overlapping the opening OP. The opening OP and the light-blocking member 256 may each have a hexagonal shape.

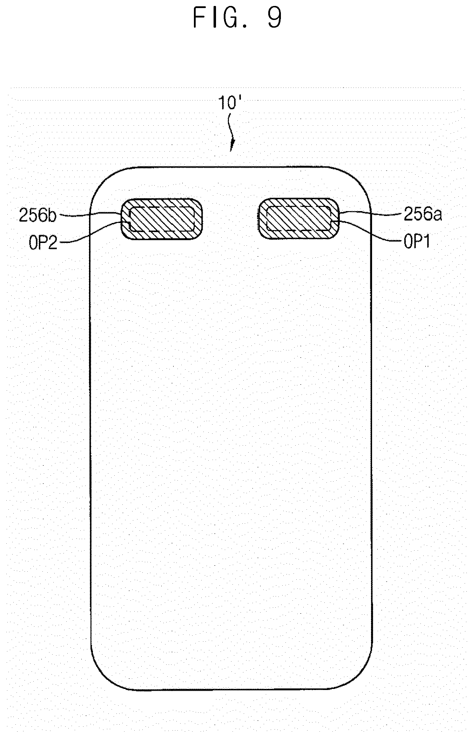

Referring to FIG. 9, a supporting member of a display device 10' may include a first opening OP1 and a second opening OP2 spaced apart from each other. The display device 10' may include a first light-blocking member 256a and a second light-blocking member 256b, which overlap the first opening OP1 and the second opening OP2, respectively.

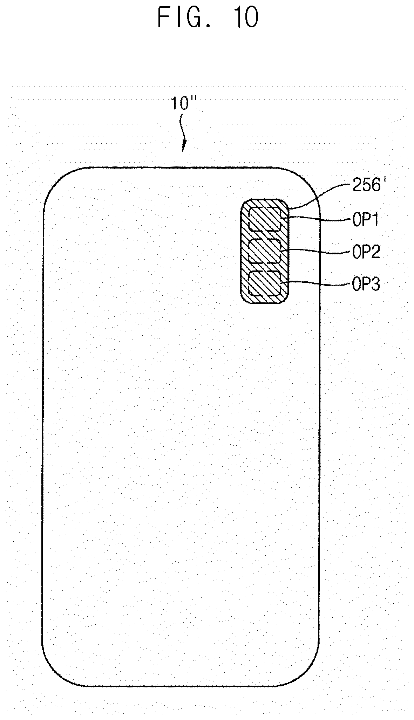

Referring to FIG. 10, a supporting member of a display device 10" may include a first opening OP1, a second opening OP2 and a third opening OP3, which are spaced apart from each other. The display device 10" may include a light-blocking member 256', which commonly overlaps the first opening OP1, the second opening OP2, and the third opening OP3.

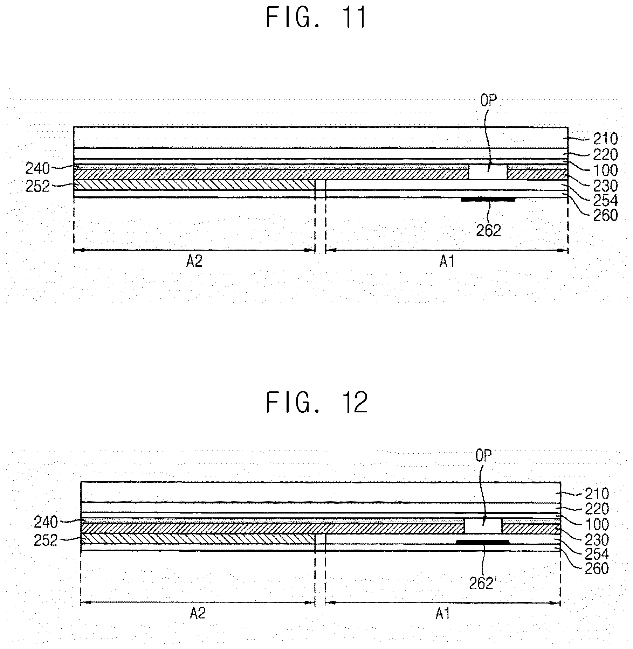

FIGS. 11, 12, and 13 are schematic cross-sectional views illustrating a display device according to embodiments.

Referring to FIG. 11, a display device may include a display panel 100, a supporting member 230 disposed under the display panel 100 and including an opening OP, a filling member 254 disposed under the supporting member 230 and overlapping a first area A1 of the supporting member 230, a heat-releasing member 252 disposed under the supporting member 230 and overlapping a second area A2 of the supporting member 230, a protective window 210 overlapping a front surface of the display panel 100, a polarization member 220 disposed between the protective window 210 and the display panel 100, an adhesive member 240 combining the display panel 100 and the supporting member 230, and a protective film 260 overlapping lower surfaces of the heat-releasing member 252 and the filling member 254.

In an embodiment, the protective film 260 may include a light-blocking layer 262 overlapping the opening OP of the supporting member 230. For example, the light-blocking layer 262 may be a printed layer formed by printing a light-blocking composition on the protective film 260.

In an embodiment, the light-blocking layer 262 may be disposed on a bottom surface of the protective film 260. However, embodiments are not limited thereto. For example, as illustrated in FIG. 12, a light-blocking layer 262' may be disposed on an upper surface of a protective film 260 to be disposed between the protective film 260 and a filling member 254. Since a thickness of the light-blocking layer 262' is much less than thicknesses of the protective film 260 and the filling member 254, the protective film 260 may be attached to the filling member 254 and a heat-releasing member 252 without a step.

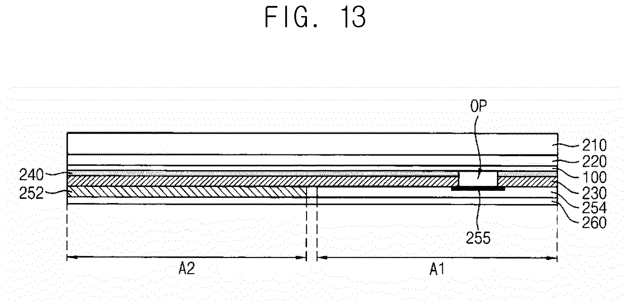

As illustrated in FIG. 13, a light-blocking layer 255 may be printed or disposed on an upper surface of a filling member 254, thereby contacting a supporting member 230.

Embodiments may be applied to various display devices. In an embodiment, for example, embodiments may be applied to a vehicle-display device, a ship-display device, an aircraft-display device, portable communication devices, display devices for display or for information transfer, a medical-display device, or the like.

## Claims

1. A display device (10) comprising:
a display panel (100);
a supporting member (230) supporting the display panel (100), the supporting member (230) including an opening (OP) which overlaps a portion of the display panel (100);
**characterized by**
a filling member (254) disposed under the supporting member (230) and overlapping a first area of the supporting member (230), the filling member (254) including an opening which overlaps the opening (OP) of the supporting member (230);
a heat-releasing member (252) disposed under the supporting member (230) and overlapping a second area of the supporting member (230); and
a light-blocking member (256) disposed in the opening (OP) of the filling member (254) and overlapping the opening (OP) of the supporting member (230).

2. The display device (10) of claim 1, further comprising a protective film (260) overlapping lower surfaces of the filling member (254), the heat-releasing member (252), and the light-blocking member (256).

3. The display device (10) of at least one of claims 1 or 2, wherein the light-blocking member (256) has a thickness equal to a thickness of the filling member (254).

4. The display device (10) of claim 3, wherein the filling member (254) has a thickness equal to a thickness of the heat-releasing member (252).

5. The display device (10) of at least one of claims 1 to 4, wherein the filling member (254) transmits light.

6. The display device (10) of at least one of claims 1 to 5, wherein the heat-releasing member (252) includes graphite.

7. The display device (10) of at least one of claims 1 to 6, wherein the display panel (100) is an organic light-emitting display panel (100).

8. The display device (10) of claim 7, wherein
the display panel (100) includes a first display area (DA1) and a second display area (DA2) which have different light transmittances in a unit area (UA), and
the second display area (DA2) overlaps the opening (OP) of the supporting member (230).

9. The display device (10) of claim 8, wherein a number of pixels in a unit area (UA) in the second display area (DA2) is less than a number of pixels in a unit area (UA) in the first display area (DA1).

10. The display device (10) of at least one of claims 1 to 9, further comprising an adhesive member (240) disposed between the supporting member (230) and the display panel (100), the adhesive member (240) including a light-blocking material.

11. The display device (10) of at least one of claims 1 to 10, wherein the supporting member (230) includes a plurality of openings (OP).
